# EUROPEAN PATENT APPLICATION

(11) **EP 2 728 624 A1**
(43) Date of publication of application: **07.05.2014**
(21) Application number: 12817928.0
(22) Date of filing: 24.07.2012
(51) Int. Cl.: H01L 31/04, H01L 21/225

(54) **SEMICONDUCTOR SUBSTRATE, MANUFACTURING METHOD THEREFOR, SOLAR-CELL ELEMENT, AND SOLAR CELL**

(30) Priority: 25.07.2011 JP 2011162645; 25.07.2011 JP 2011162646; 25.07.2011 JP 2011162647
(71) Applicant: Hitachi Chemical Company, Ltd., Chiyoda-ku Tokyo 100-6606 (JP)
(72) Inventor: SATO, Tetsuya, Tsukuba-shi Ibaraki 300-4247 (JP); YOSHIDA, Masato, Tsukuba-shi Ibaraki 300-4247 (JP); NOJIRI, Takeshi, Tsukuba-shi Ibaraki 300-4247 (JP); MACHII, Yoichi, Tsukuba-shi Ibaraki 300-4247 (JP); IWAMURO, Mitsunori, Tsukuba-shi Ibaraki 300-4247 (JP); ORITA, Akihiro, Tsukuba-shi Ibaraki 300-4247 (JP)
(74) Representative: HOFFMANN EITLE
(86) International application number: PCT/JP2012/068720
(87) International publication number: WO 2013/015284

(57) **Abstract**

The invention provides a semiconductor substrate having a semiconductor layer and an impurity diffusion layer, the impurity diffusion layer comprising: at least one metal atom selected from the group consisting of K, Na, Li, Ba, Sr, Ca, Mg, Be, Zn, Pb, Cd, V, Sn, Zr, Mo, La, Nb, Ta, Y, Ti, Zr, Ge, Te and Lu; and at least one impurity atom selected from the group consisting of an n-type impurity atom and a p-type impurity atom.

## Description

### Technical Field

The present invention relates to a semiconductor substrate and a production method thereof, a photovoltaic cell element, and a photovoltaic cell.

### Background Art

A method of producing an n-type diffusion layer of a conventional silicon photovoltaic cell element will be explained.

First, a p-type silicon substrate, on which a texture structure is formed in order to improve the efficiency by promoting the light confinement effect, is prepared. Subsequently, an n-type diffusion layer is uniformly formed on the p-type silicon substrate by performing a treatment for several ten minutes in a mixed gas atmosphere of phosphorous oxychloride (POCl₃), nitrogen and oxygen at a temperature of from 800°C to 900°C. In this conventional method, the surface of the silicon is oxidized and an amorphous film of PSG (phosphosilicate glass) is formed thereon, and only phosphorus atoms are diffused into the silicon substrate and an n-type diffusion layer, in which phosphorus atoms exist at high concentration is formed.

In the field of semiconductor manufacturing, a method of forming an n-type diffusion layer by applying a solution including a phosphate such as phosphorus pentaoxide (P₂O₅) or ammonium dihydrogenphosphate (NH₄H₂PO₄) (see, for example, Japanese Patent Application Laid-Open (JP-A) No. 2002-75894). In this method, an n-type diffusion layer is formed equally with the gas-phase reaction method using a mixed gas as described above.

Further, in either method, an n-type diffusion layer is formed not only at a front surface but also at a side surface and a back surface, as a result of diffusion of phosphorus.

The n-type diffusion layer that is formed at the back surface needs to be converted to a p⁺- type diffusion layer. For this purpose, an aluminum paste that includes aluminum, which is an element in group 13, is applied onto the n-type diffusion layer at the back surface. Then, the semiconductor substrate is subjected to a thermal treatment, whereby the n-type diffusion layer is converted to a p⁺- type diffusion layer due to diffusion of aluminum, and an ohmic contact is also achieved.

A technique in which a boron compound is used as a diffusion source instead of aluminum is proposed (see, for example, JP-A No. 2002-539615), and a diffusing agent composition in which B₂O₃, Al₂O₃ or P₂O₅ is dispersed in an organic solvent is proposed (see, for example, JP-A No. 2011-71489).

### [General Description of the Invention]

### [Problem to be Solved by the Invention]

As mentioned above, in the formation of an n-type diffusion layer and a p⁺- type diffusion layer, n-type impurity atoms such as phosphorus atoms or p-type impurity atoms such as boron atoms are diffused into a silicon substrate by substituting for silicon atoms. In particular, since a phosphorus atom and a boron atom have an atomic radius that is significantly smaller than the atomic radius of a silicon atom, these atoms can substitute for silicon atoms at high concentration. However, a large number of lattice defects are generated as a result of substitution of silicon atoms with phosphorus or boron atoms, and a degree of plastic deformation is increased. The defects may cause recombination of photogenerated carriers in a photovoltaic cell element, and its light conversion characteristics may deteriorate.

The invention has been made in view of the problems as set forth above, and aims to provide a semiconductor substrate that exhibits an excellent light conversion efficiency, and a method of producing the semiconductor substrate. The invention also aims to provide a photovoltaic cell element and a photovoltaic cell that are produced by using the semiconductor substrate.

### [Means for Solving the Problem]

The following are specific embodiments for solving the problem, and these embodiments are included in the present invention.
<1> A semiconductor substrate having a semiconductor layer and an impurity diffusion layer, the impurity diffusion layer comprising: at least one metal atom selected from the group consisting of K, Na, Li, Ba, Sr, Ca, Mg, Be, Zn, Pb, Cd, V, Sn, Zr, Mo, La, Nb, Ta, Y, Ti, Zr, Ge, Te and Lu; and at least one impurity atom selected from the group consisting of an n-type impurity atom and a p-type impurity atom.
<2> The semiconductor substrate according to <1>, wherein a content of the metal atom at a surface of the impurity diffusion layer is 1×10¹⁷ atoms/cm³ or more.
<3> The semiconductor substrate according to <1> or <2>, wherein the n-type impurity atom is at least one selected from the group consisting of P and Sb.
<4> The semiconductor substrate according to <1> or <2>, wherein the p-type impurity atom is at least one selected from the group consisting of B and Ga.
<5> The semiconductor substrate according to any one of <1> to <3>, wherein the impurity diffusion layer comprises an n-type impurity atom, and is formed by performing a thermal treatment to a glass powder that is applied onto at least one surface of the semiconductor layer, the glass powder comprising: at least one n-type impurity-containing substance selected from the group consisting of P₂O₃, P₂O₅ and Sb₂O₃; and at least one glass component substance selected from the group consisting of SiO₂, K₂O, Na₂O, Li₂O, BaO, SrO, CaO, MgO, BeO, ZnO, PbO, CdO, V₂O₅, SnO, ZrO₂ and MoO₃.
<6> The semiconductor substrate according to any one of <1>, <2> and <4>, wherein the impurity diffusion layer comprises a p-type impurity atom, and is formed by performing a thermal treatment to a glass powder that is applied onto at least one surface of the semiconductor layer, the glass powder comprising: at least one p-type impurity-containing substance selected from the group consisting of B₂O₃ and Ga₂O₃; and at least one glass component substance selected from the group consisting of SiO₂, K₂O, Na₂O, Li₂O, BaO, SrO, CaO, MgO, BeO, ZnO, PbO, CdO, V₂O₅, SnO, ZrO₂ and MoO₃.
<7> A photovoltaic cell element, comprising the semiconductor substrate according to any one of <1> to <6>, and an electrode disposed on the impurity diffusion layer.
<8> A photovoltaic cell, comprising the photovoltaic cell element according to <7> and a wiring material disposed on the electrode.
<9> A method of producing the semiconductor substrate according to any one of <1> to <6>, the method comprising: a step of applying, onto at least one surface of the semiconductor layer, an impurity diffusion layer-forming composition that comprises a glass powder and a dispersion medium, the glass powder including at least one impurity atom selected from the group consisting of an n-type impurity atom and a p-type impurity atom; and a step of forming an impurity diffusion layer by performing a thermal diffusion treatment on the applied impurity diffusion layer-forming composition.

### [Effect of the Invention]

According to the invention, it is possible to provide a semiconductor substrate that exhibits an excellent light conversion efficiency, a method of producing the semiconductor substrate, a photovoltaic cell element, and a photovoltaic cell.

### [Brief Explanation of the Drawings]

Fig. 1 is a cross section that schematically illustrates an example of a process of producing a photovoltaic cell element according to the invention.
Fig. 2A is a plan view of a front side of a photovoltaic cell element according to the invention.
Fig. 2B is a perspective view of an enlarged portion of the photovoltaic cell element shown in Fig. 2A.

### [Embodiment for Implementing the Invention]

In the present specification, the term "process" includes not only an independent process but also a process that cannot be clearly distinguished from other processes, as long as its intended purpose can be achieved. The numerical range expressed by "from A to B" indicates a range including A and B as a minimum value and a maximum value. When two or more substances that correspond to the same component exist in a composition, the amount of the component refers to the total amount of the substances.

### <Semiconductor Substrate>

The semiconductor substrate of the invention has a semiconductor layer and an impurity diffusion layer, and the impurity diffusion layer comprises: at least one metal atom selected from the group consisting of K, Na, Li, Ba, Sr, Ca, Mg, Be, Zn, Pb, Cd, V, Sn, Zr, Mo, La, Nb, Ta, Y, Ti, Zr, Ge, Te and Lu (hereinafter, also referred to as the "specific metal atom group"); and at least one impurity atom selected from the group consisting of an n-type impurity atom and a p-type impurity atom.

By including at least one kind of metal atom selected from the specific metal atom group in the impurity diffusion layer, a semiconductor substrate that exhibits an excellent light conversion efficiency can be obtained. The reason why an excellent light conversion efficiency is achieved is thought to be that a distortion in the impurity diffusion layer is relaxed, for example.

Currently, a photovoltaic cell element having a so-called selective emitter structure, in which two impurity diffusion layers having different impurity concentrations are provided and an electrode is formed on the impurity diffusion layer having a higher impurity concentration, or a photovoltaic cell element having a back contact structure, in which both an n-type diffusion layer and a p-type diffusion layer are formed at the back surface, are under development in pursuit of further improvements in efficiency. In the conventional method, it is difficult to distinguish a region at which an impurity diffusion layer is formed from other regions. Therefore, it is difficult to determine the position for an electrode to be formed on the impurity diffusion layer having a higher impurity concentration or on the n-type and p-type impurity diffusion layers formed on the same surface. As a result, deterioration in characteristics of the photovoltaic cell element may be caused.

However, in the semiconductor substrate of the invention, since the impurity diffusion layer includes at least one kind of metal atom selected from the specific metal atom group (hereinafter, also referred to as a "specific metal atom"), it is possible to distinguish a region at which a diffusion layer is formed from other regions. Therefore, an electrode can be formed on an impurity diffusion layer of a semiconductor substrate in a highly precise and easy manner. By using the semiconductor substrate, a photovoltaic cell element having a selective emitter structure or a back contact structure can be produced in an efficient manner without causing deterioration in characteristics.

The semiconductor layer may be either a p-type semiconductor layer or an n-type semiconductor layer. The semiconductor layer is preferably a p-type semiconductor layer, more preferably a p-type silicon layer.

The impurity diffusion layer of the semiconductor substrate includes at least one kind of metal atom selected from the specific metal atom group. From the viewpoint of distortion relaxation and distinguishability, the semiconductor substrate preferably includes at least one kind of metal atom selected from the group consisting of K, Na, Li, Ba, Sr, Ca, Mg, Zn, Pb, Cd, V, Sn, Zr, Mo, La, Nb, Ta, Y, Ti, Ge, Te and Lu, more preferably at least one kind of metal atom selected from the group consisting of K, Na, Li, Ba, Ca, Mg, Zn, Sn, Ti, Te, V and Pb, further preferably at least one kind of metal atom selected from the group consisting of Ca and Mg.

The content of the specific metal atom included in the impurity diffusion layer is not particularly limited as long as the effect of the invention is achieved. From the viewpoint of distortion relaxation and distinguishability, the content of the specific metal atom at a surface of the impurity diffusion layer is preferably 1×10¹⁷ atoms/cm³ or more, more preferably from 1×10¹⁷ atoms/cm³ to 1×10²⁰ atoms/cm³.

The kind and the content of the specific metal atom in the impurity diffusion layer can be measured by performing secondary ion mass spectrometry (SIMS) by an ordinary method with IMS-7F (AMETEK, Inc - CAMECA SAS).

Specifically, the kind and the content of the specific metal atom are measured by performing secondary ion mass spectrometry while sputtering a region of a specific area as a measurement target in a depth direction. The content of the specific metal atom at a surface is defined by a concentration of the specific metal atom measured at 0.025 µm in depth from the surface.

The semiconductor substrate can be produced by, for example, the method of producing the semiconductor substrate as described below.

### [Method of Producing Semiconductor Substrate]

The method of producing the semiconductor substrate of the invention includes: a step of applying, onto at least one surface of the semiconductor layer, an impurity diffusion layer-forming composition that includes a glass powder and a dispersion medium, the glass powder including at least one impurity atom selected from the group consisting of an n-type impurity atom and a p-type impurity atom; and a step of forming an impurity diffusion layer by performing a thermal diffusion treatment to the applied impurity diffusion layer-forming composition. As necessary, the method includes other processes.

The method of producing the semiconductor substrate uses an impurity diffusion layer-forming composition that includes a glass powder that includes at least one kind of impurity atom selected from the group consisting of an n-type impurity atom (hereinafter, also referred to as a "donor element") and a p-type impurity atom (hereinafter, also referred to as an "acceptor element") and a dispersing medium. The impurity diffusion layer-forming composition may include other additives as necessary, in view of coatability or the like.

The impurity diffusion layer-forming composition is a material that includes at least one kind of impurity atom selected from the group consisting of an n-type impurity atom and a p-type impurity atom, and an impurity diffusion layer can be formed by applying the material to a semiconductor substrate and allowing the impurity atom to thermally diffuse. In a case in which the impurity diffusion layer-forming composition of the invention is used, a side etching process, which is a necessary process in a conventional gas phase reaction method, can be omitted and the process can be simplified. Further, for example, in a case in which an n-type diffusion layer is formed on a p-type semiconductor substrate by a gas phase method, a process of converting the n-type diffusion layer formed at the back surface into a p⁺-type diffusion layer can be omitted. Accordingly, there are less restrictions in the manner of forming a p⁺-type diffusion layer at the back surface and the material, the shape or the thickness of the back surface electrode. Therefore, the production method, the material and the shape may be selected from more options. In addition, in a case in which a p-type impurity diffusion layer-forming composition is applied for the formation of a p⁺-type diffusion layer, generation of an internal stress in a semiconductor substrate that is due to the thickness of the back surface electrode is suppressed, thereby suppressing warpage of the semiconductor substrate.

The glass powder included in the impurity diffusion layer-forming composition is melted during sintering, and forms a glass layer on the impurity diffusion layer. A glass layer is formed on an impurity diffusion layer also in a conventional gas phase reaction method or a method of applying a phosphate solution. The glass layer formed in the present invention can be removed by performing etching in a similar manner to the conventional method. Accordingly, the method of using the impurity diffusion layer-forming composition does not generate an unnecessary product or does not require additional processes as compared with the conventional method.

In addition, the impurity atom in the glass powder does not diffuse even during sintering, and formation of an impurity diffusion layer not only at a front surface but also at a back surface or a side surface can be suppressed. It is thought that the impurity atom is difficult to diffuse because it is bound to an element of other components in the glass powder, or is incorporated in the glass.

As described above, the impurity diffusion layer-forming composition enables formation of an impurity diffusion layer at a desired portion at a desired concentration, and enables formation of a selective region with a high impurity concentration. On the other hand, it is generally difficult to form a selective region with a high impurity concentration by a conventional method of forming an impurity diffusion layer, such as a gas phase reaction method or a method of using a solution including a phosphate or a borate.

The glass powder that includes at least one kind of impurity atom selected from the group consisting of an n-type impurity atom and a p-type impurity atom is described.

The glass powder that includes the impurity atom includes a substance that includes an impurity atom and a substance that includes the specific metal atom. The glass powder preferably includes a further glass component substance, as necessary. The glass component substance may be a substance that includes the specific metal atom.

The n-type impurity atom is an element that can form an n-type diffusion layer by diffusing (doping) into a semiconductor substrate. An element in group 15 can be used as the n-type impurity atom, and examples include P (phosphorus), Sb (antimony), Bi (bismuth) and As (arsenic). From the viewpoint of safety and ease of vitrification, P or Sb is preferred.

Examples of the n-type impurity-containing substance that is used for introducing an n-type impurity atom into a glass powder include P₂O₃, P₂O₅, Sb₂O₃, Bi₂O₃ and As₂O₃, preferably at least one selected from P₂O₃, P₂O₅ and Sb₂O₃.

The p-type impurity atom is an element that can form a p-type diffusion layer by diffusing (doping) into a silicon substrate. An element in group 13 can be used as the p-type impurity atom, and examples include B (boron), Al (aluminum) and Ga (gallium).

Examples of the p-type impurity-containing substance that is used for introducing a p-type impurity atom into a glass powder include B₂O₃, Al₂O₃ and Ga₂O₃, preferably at least one selected from B₂O₃, Al₂O₃ and Ga₂O₃.

The glass powder preferably includes at least one kind of specific metal atom selected from the group consisting of K, Na, Li, Ba, Sr, Ca, Mg, Be, Zn, Pb, Cd, V, Sn, Zr, Mo, La, Nb, Ta, Y, Ti, Zr, Ge, Te and Lu, in addition to the impurity-containing substance. Examples of the substance that includes the specific metal atom include K₂O, Na₂O, Li₂O, BaO, SrO, CaO, MgO, BeO, ZnO, PbO, CdO, V₂O₅, SnO, ZrO₂, MoO₃, La₂O₃, Nb₂O₅, Ta₂O₅, Y₂O₃, TiO₂, ZrO₂, GeO₂, TeO₂ and Lu₂O₃.

In a case in which the impurity atom has a smaller atomic radius than a silicon atom, such as a phosphorus atom or a boron atom, the specific metal atom is preferably selected from a metal atom having a large atomic radius. In that case, a lattice distortion generated in the diffusion layer can be relaxed more effectively.

The content of the substance that includes the specific metal atom in the glass powder is not particularly limited. Generally, the content of the substance that includes the specific metal atom is preferably from 0.1% by mass to 95% by mass, more preferably from 0.5% by mass to 90% by mass.

As necessary, the melting temperature, softening temperature, glass transition point, chemical endurance or the like of the glass powder may be regulated by adjusting the ratio of components. Further, the glass powder preferably includes the following components.

Examples of the glass component substance include SiO₂, K₂O, Na₂O, Li₂O, BaO, SrO, CaO, MgO, BeO, ZnO, PbO, CdO, V₂O₅, SnO, ZrO₂ and MoO₃, and at least one selected therefrom is preferably used.

Preferably, the glass powder does not include a heavy metal atom that may act as a killer element that promotes recombination of carriers in a semiconductor substrate. In a case of an n-type diffusion layer-forming composition, it is preferred that a p-type impurity atom is not included. In a case of a p-type diffusion layer-forming composition, it is preferred that an n-type impurity atom is not included. Examples of the heavy metal atom that may act as a killer element include Fe, Co, Ni, Mn, W, Cu and Cr. Examples of the p-type impurity atom include an element in group 13, and examples of the n-type impurity atom include an element in group 15.

Examples of the glass powder that includes an n-type impurity atom include a system that includes both the n-type impurity-containing substance and the glass component substance. Specific examples include a system that includes P₂O₅ as an n-type impurity-containing substance, such as P₂O₅-K₂O, P₂O₅-Na₂O, P₂O₅-Li₂O, P₂O₅-BaO, P₂O₅-SrO, P₂O₅-CaO, P₂O₅-MgO, P₂O₅-BeO, P₂O₅-ZnO, P₂O₅-CdO, P₂O₅-PbO, P₂O₅-V₂O₅, P₂O₅-SnO, P₂O₅-GeO₂ and P₂O₅-TeO₂, and the systems as described above in which Sb₂O₃ is included instead of P₂O₅ as an n-type impurity-containing substance.

The examples mentioned above are composite glasses that include two components, but a composite glass that includes three or more components, such as P₂O₅-SiO₂-CaO and P₂O₅-SiO₂-MgO, may also be used as necessary.

Examples of the glass powder that includes a p-type impurity atom include a system in which a p-type impurity-containing substance and a glass component substance are included. Specific examples include a glass powder that includes B₂O₃ as a p-type impurity-containing substance, such as B₂O₃-ZnO, B₂O₃-PbO, and a system including only B₂O₃, and a glass powder that includes Al₂O₃ as a p-type impurity-containing substance, such as Al₂O₃-SiO₂.

The examples mentioned above are composite glasses that include two components, but a composite glass that includes three or more components, such as B₂O₃-SiO₂-Na₂O, may also be used.

The content of the glass component substance in the glass powder is preferably determined in view of the melting temperature, softening temperature, glass transition temperature or chemical endurance. Generally, the content of the glass component substance in the glass powder is preferably from 0.1% by mass to 95% by mass, more preferably from 0.5% by mass to 90% by mass.

The softening point of the glass powder is preferably from 200°C to 1000°C, more preferably from 300°C to 900°C, from the viewpoint of diffusibility during a diffusion treatment or dripping.

Examples of the shape of the glass powder includes an approximate sphere shape, a flat shape, a block shape, a plate shape and a scale shape. From the viewpoint of coatability of a diffusion layer-forming composition with respect to a substrate or uniform diffusibility, the shape of the glass powder is preferably an approximate sphere shape, a flat shape or a plate shape. The average particle diameter of the glass powder is preferably 100 µm or less. In a case in which a glass powder having an average particle diameter of 100 µm or less is used, a flat and smooth coating is readily obtained. Further, the average particle diameter of the glass powder is preferably 50 µm or less. The lower limit of the average particle diameter of the glass powder is not particularly limited, but is preferably 0.01 µm or more.

The average particle diameter of the glass powder refers to a voltage average particle diameter, and is measured by a laser scattering diffraction particle size distribution analyzer or the like.

The glass powder that includes an impurity atom can be prepared by the following processes.

First, the raw materials, such as the impurity-containing substance and the glass component substance are measured and charged in a crucible. Examples of the material for the crucible include platinum, platinum-rhodium, iridium, alumina, quartz and carbon, and the material may be selected in view of the melting temperature, atmosphere, reactivity with a melted substance and the like.

Next, the raw materials are melted by heating in an electric furnace at an appropriate temperature to the glass composition. The raw materials are preferably agitated so that a uniform melt is obtained.

Subsequently, the obtained melt is cast on a zirconia substrate or a carbon substrate to allow to vitrify.

Finally, the glass is pulverized into a powder. The pulverization may be performed with a known method, such as a jet mill, a bead mill or a ball mill.

The content of the glass powder that includes an impurity atom in the impurity diffusion layer-forming composition is determined in view of coatability or impurity diffusibility. Generally, the content of the glass powder in the impurity diffusion layer-forming composition is preferably from 0.1% by mas to 95% by mass, more preferably from 1% by mass to 90% by mass, further preferably from 1.5% by mass to 85% by mass, particularly preferably from 2% by mass to 80% by mass.

In the following, a dispersing medium is explained.

The dispersing medium is a medium in which the glass powder is dispersed in the impurity diffusion layer-forming composition. Specific examples of the dispersing medium include a binder and a solvent.

Examples of the binder include polyvinyl alcohol, polyacrylamide resin, polyvinylamide resin, polyvinyl pyrrolidone resin, polyethylene oxide resin, polysulfonic acid resin, acrylamide alkyl sulfonic acid resin, cellulose ether such as carboxymethyl cellulose, hydroxyethyl cellulose and ethyl cellulose, cellulose derivatives, gelatin, starch and starch derivatives, sodium alginate and derivatives thereof, xanthan and xanthan derivatives, guar and guar derivatives, scleroglucan and scleroglucan derivatives, tragacanth and tragacanth derivatives, dextrin and dextrin derivatives, (meth)acrylic acid resin, (meth)acrylic acid ester resin such as alkyl (meth)acrylate resin and dimethylaminoethyl (meth)acrylate resin, butadiene resin, styrene resin, copolymers of these resins, and siloxane resin. These binders may be used alone or as a combination of two or more kinds.

The molecular weight of the binder is not particularly limited, and is preferably adjusted in view of a desired viscosity of the impurity diffusion layer-forming composition. For example, the weight-average molecular weight may be from 10,000 to 500,000, preferably from 50,000 to 300,000.

The content of the binder in the impurity diffusion layer-forming composition is not particularly limited, and is preferably adjusted in view of a desired viscosity of the composition or ejectability of the composition in an inkjet method. For example, the content of the binder may be from 0.5% by mass to 10% by mass, preferably from 2% by mass to 8% by mass.

Examples of the solvent include ketone solvents such as acetone, methyl ethyl ketone, methyl-n-propyl ketone, methyl isopropyl ketone, methyl-n-butyl ketone, methyl isobutyl ketone, methyl-n-penthyl ketone, methyl-n-hexyl ketone, diethyl ketone, dipropyl ketone, diisobutyl ketone, trimethyl nonanone, cyclohexanone, cyclopentanone, methyl cyclohexanone, 2,4-pentanedione, acetonyl acetone; ether solvents such as diethyl ether, methyl ethyl ether, methyl-n-propyl ether, diisopropyl ether, tetrahydrofuran, methyltetrahydrofuran, dioxane, dimethyl dioxane, ethylene glycol dimethyl ether, ethylene glycol diethyl ether, ethylene glycol di-n-propyl ether, ethylene glycol dibutyl ether, diethylene glycol dimethyl ether, diethylene glycol diethyl ether, diethylene glycol methyl ethyl ether, diethylene glycol methyl-n-propyl ether, diethylene glycol methyl-n-butyl ether, diethylene glycol di-n-propyl ether, diethylene glycol di-n-butyl ether, diethylene glycol methyl-n-hexyl ether, triethylene glycol diemethyl ether, triethylene glycol diethyl ether, triethylene glycol methyl ethyl ether, triethylene glycol methyl-n-butyl ether, triethylene glycol di-n-butyl ether, triethylene glycol methyl-n-hexyl ether, tetraethylene glycol dimethyl ether, tetraethyelne glycol diethyl ether, tetradiethylene glycol methyl ethyl ether, tetraethylene glycol methyl-n-butyl ether, diethylene glycol di-n-butyl ether, tetraethyelne glycol methyl-n-hexyl ether, tetraethyelne glycol di-n-butyl ether, propylene glycol dimethyl ether, propylene glycol diethyl ether, propylene glycol di-n-propyl ether, propylene glycol dibutyl ether, dipropylene glycol dimethyl ether, dipropylene glycol diethyl ether, dipropylene glycol methyl ethyl ether, dipropylene glycol methyl-n-butyl ether, dipropylene glycol di-n-propyl ether, dipropylene glycol di-n-butyl ether, dipropylene glycol methyl-n-hexyl ether, tripropylene glycol dimethyl ether, tripropylene glycol diethyl ether, tripropylene glycol methyl ethyl ether, tripropylene glycol methyl-n-butyl ether, tripropylene glycol di-n-butyl ether, tripropylene glycol methyl-n-hexyl ether, tetrapropylene glycol dimethyl ether, tetrapropylene glycol diethyl ether, tetradipropylene glycol methyl ethyl ether, tetrapropylene glycol methyl-n-butyl ether, dipropylene glycol di-n-butyl ether, tetrapropylene glycol methyl-n-hexyl ether and tetrapropylene glycol di-n-butyl ether; ester solvents such as methyl acetate, ethyl acetate, n-propyl acetate, isopropyl acetate, n-butyl acetate, isobutyl acetate, sec-butyl acetate, n-pentyl acetate, sec-pentyl acetate, 3-methoxybutyl acetate, methyl pentyl acetate, 2-ethyl butyl acetate, 2-ethyl hexyl acetate, 2-(2-butoxyethocy)ethyl acetate, benzyl acetate, cyclohexyl acetate, methyl cyclohexyl acetate, nonyl acetate, methyl acetoacetate, ethyl acetoacetate, diethylene glycol methyl ether acetate, diethylene glycol monoethyl ether acetate, dipropylene glycol methyl ether acetate, dipropylene glycol ethyl ether acetate, glycol diacetate, methoxy triglycol acetate, ethyl propionate, n-butyl propionate, isoamyl propionate, diethyl oxalate, di-n-butyl oxalate, methyl lactate, ethyl lactate, n-butyl lactate, n-amyl lactate, ethylene glycol methyl ether propionate, ethylene glycol ethyl ether propionate, ethylene glycol methyl ether acetate, ethylene glycol ethyl ether acetate, propylene glycol methyl ether acetate, propylene glycol ethyl ether acetate, propylene glycol propyl ether acetate, γ-butyrolactone and γ-valerolactone; nonprotic polar solvents such as acetonitrile, N-acetonitrile, N-methyl pyrrolidinone, N-ethyl pyrrolidinone, N-propyl pyrrolidinone, N-butyl pyrrolidinone, N-hexyl pyrrolidinone, N-cyclohexyl pyrrolidinone, N,N-dimethyl formamide, N,N-dimethyl acetamide and dimethyl sulfoxide; alcohol solvents such as methanol, ethanol, n-propanol, isopropanol, n-butanol, isobutanol, sec-butanol, tert-butanol, n-pentanol, isopentanol, 2-methylbutanol, sec-pentanol, tert-pentanol, 3-methoxybutanol, n-hexanol, 2-methylpentanol, sec-hexanol, 2-ethylbutanol, sec-heptanol, n-octanol, 2-ethylhexanol, sec-octanol, n-nonyl alcohol, n-decanol, sec-undecyl alcohol, trimethyl nonyl alcohol, sec-tetradecyl alcohol, sec-heptadecyl alcohol, phenol, cyclohexanol, methylcyclohexanol, benzyl alcohol, ethylene glycol, 1,2-propylene glycol, 1,3-butylene glycol, diethyhlene glycol, dipropylene glycol, triethylene glycol and tripropylene glycol; glycol monoether solvents such as ethylene glycol monomethyl ether, ethylene glycol monoethyl ether, ethylene glycol monophenyl ether, diethylene glycol monomethyl ether, diethylene glycol monoethyl ether, diethylene glycol mono-n-butyl ether, diethylene glycol mono-n-hexyl ether, ethoxy triglycol, tetraethylene glycol mono-n-butyl ether, propylene glycol monomethyl ether, dipropylene glycol monomethyl ether, dipropylene glycol monoethyl ether and tripropylene glycol monomethyl ether; terpene solvents such as α-terpinene, α-terpineol, myrcene, alloocimene, limonene, dipentene, α-pinene, β-pinene, terpineol, carvone, ocimene and phellandrene; and water. There solvents may be used alone or in a combination of two or more kinds.

In view of coatability of an impurity diffusion layer-forming composition with respect to a substrate, the solvent is preferably at least one selected from the group consisting of α-terpineol, diethylene glycol mono-n-butyl ether and 2-(2-butoxyethoxy)ethyl acetate.

The content of the dispersing medium in the impurity diffusion layer-forming composition is determined in view of the coatability and the concentration of the n-type impurity or the p-type impurity.

The viscosity of the impurity diffusion layer-forming composition is preferably from 10 mPa·s to 1,000,000 mPa·S, more preferably from 50 mPa·s to 500,000 mPa·s, from the viewpoint of coatability.

The impurity diffusion layer-forming composition may include other additives. Examples of the additives include a surfactant, metal particles such as silicon particles, and a thickening agent.

Examples of the thickening agent include the materials mentioned as the exemplary binders. When the composition includes a thickening agent, the content thereof may be determined such that the viscosity of the impurity diffusion layer-forming composition is from 20 Pa·s to 1,000 Pa·s, for example.

By including a thickening agent such that the viscosity of the impurity diffusion layer-forming composition is from 20 Pa·s to 1,000 Pa·s, applicability of the composition with respect to a semiconductor layer is improved and reproducibility of fine lines may be excellent, for example.

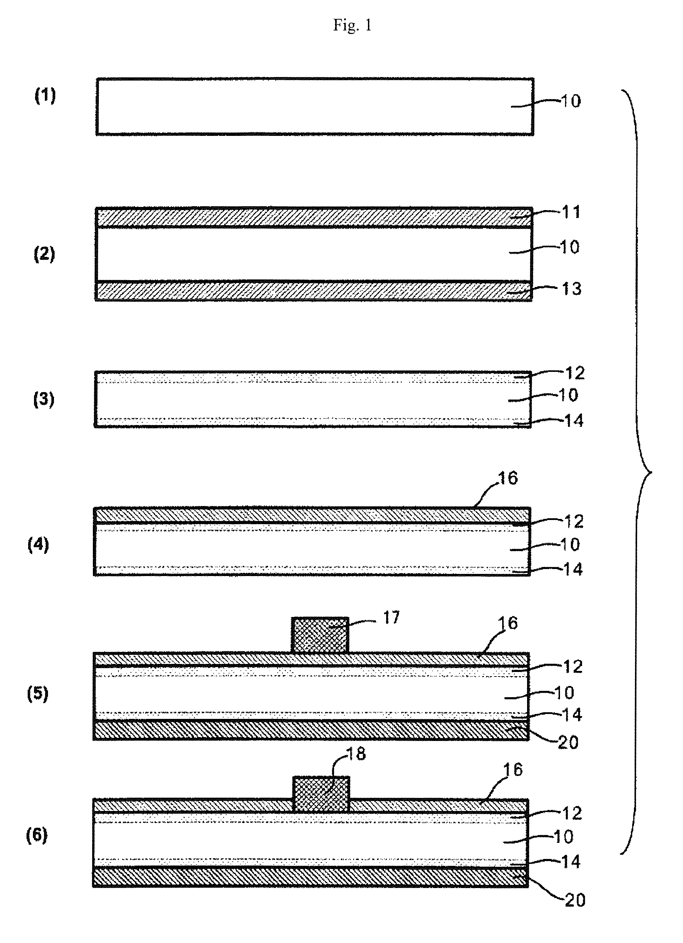

In the following, a specific example of the method of producing a semiconductor substrate of the invention is explained with reference to Fig. 1. Fig. 1 is a schematic sectional view of an example of the production process of the photovoltaic cell element of the invention. In the drawings, the same number indicates the same component.

In Fig. 1 (1), an alkali solution is applied to a silicon substrate, which is a p-type semiconductor substrate 10, whereby a damage layer is removed and a texture structure is obtained by performing etching.

Specifically, a damage layer that is formed at a silicon surface upon slicing the substrate from an ingot is removed with a 20 mass% caustic soda. Subsequently, a texture structure is formed by performing etching with a mixed solution of 1 mass% caustic soda and 10 mass% isopropyl alcohol (in the drawings, a texture structure is omitted). By forming a texture structure at a light-receiving surface (front surface) of the semiconductor substrate, a light confinement effect is enhanced and the efficiency of a photovoltaic cell element is increased.

In Fig. 1 (2), an n-type diffusion layer-forming composition 11 is applied onto the front surface (light-receiving surface) of a p-type semiconductor substrate 10. The application method is not particularly limited, and may be selected from known methods such as a printing method, a spin coating method, brush painting, a spray method, a doctor blade method, a roll coater method and an inkjet method.

The application amount of the n-type diffusion layer-forming composition is not particularly limited. For example, the application amount can be adjusted such that the amount of the glass powder is from 0.01 g/m² to 100 g/m², preferably from 0.1 g/m² to 10 g/m².

After the application, a drying process for volatilizing a solvent in the impurity diffusion layer-forming composition is provided as necessary, depending on the composition of the impurity diffusion layer-forming composition. In that case, the drying is performed at a temperature of approximately from 80°C to 300°C, for a time of from 1 minute to 10 minutes in a case of using a hot plate or from 10 minutes to 30 minutes in a case of using a dryer or the like. The drying conditions depend on the composition of the solvent in the impurity diffusion layer-forming composition, and the invention is not limited to the conditions as mentioned above.

Further, the p-type semiconductor substrate 10 onto which the n-type diffusion layer-forming composition has been applied is preferably subjected to a thermal treatment in an atmosphere including oxygen or while flowing an oxygen gas (for example, air) at a temperature of from 200°C to 800°C, for example. The temperature for the thermal treatment is preferably from 300°C to 800°C, more preferably from 400°C to 700°C, further preferably from 400°C to 600°C. By performing the thermal treatment, a large part of the dispersing medium (preferably a binder) can be removed, and an n-type diffusion layer having more favorable characteristics can be formed.

The time for the thermal treatment is not particularly limited, and can be selected according to the composition of the n-type diffusion layer-forming composition. For example, the time can be selected from a range of from 1 minute to 30 minutes.

In the production method of the invention, a method of producing a p⁺-type diffusion layer (high density electric field layer) 14 at a back surface is not particularly limited to a method of converting an n-type diffusion layer formed of aluminum, and may be selected from known methods. Therefore, the production method can be chosen from a wider range of options. For example, a p⁺-type diffusion layer (high density electric field layer) 14 may be formed by applying a p-type diffusion layer-forming composition layer 13, which is an impurity diffusion layer-forming composition.

The method of applying a p-type diffusion layer-forming composition layer 13 to a back surface of the n-type semiconductor substrate 10 is similar to a method of applying the n-type diffusion layer-forming composition onto a p-type semiconductor substrate as mentioned above.

By performing a thermal diffusion treatment to the p-type diffusion layer-forming composition layer 13 that has been applied at the back surface, in a similar manner to a thermal diffusion treatment to the n-type diffusion layer-forming composition layer 11 as described later, a p⁺-type diffusion layer (high density electric field layer) 14 can be formed at the back surface. In that case, the thermal diffusion treatment for the p-type diffusion layer-forming composition layer 13 is preferably performed at the same time as the thermal diffusion treatment for the p-type diffusion layer-forming composition 11.

Subsequently, the p-type semiconductor substrate 10 on which the n-type diffusion layer-forming composition layer 11 has been formed is subjected to a thermal diffusion treatment at a temperature of from 600°C to 1200°C. By performing the thermal diffusion treatment, as shown in Fig. 1(3), n-type impurity atoms are diffused into the p-type semiconductor substrate 10, and an n-type diffusion layer 12 is formed. At this time, the specific metal atom included in the n-type diffusion layer-forming composition 11 is diffused into the n-type diffusion layer 12. In this way, lattice distortion, which is caused by plastic deformation that occurs in a region in which n-type impurity atoms (such as phosphorous atoms) are diffused at high concentration, is relaxed and generation of defects is suppressed.

The specific metal atoms diffused into the n-type diffusion layer are preferably included in a surface layer of the n-type diffusion layer at a concentration range of 1 ×10¹⁷ atoms/cm³ or more. From the viewpoint of suppressing the diffusion of the n-type impurity atoms by decreasing the lattice defects, the concentration is preferably from 1×10¹⁷ atoms/cm³ to 1×10²⁰ atoms/cm³ so that the concentration is not too high.

The thermal diffusion treatment may be performed by using a known continuous-type furnace, a batch-type furnace, or the like. The atmosphere in the furnace during the thermal diffusion treatment may be adjusted according to the content of the n-type impurity atoms included in the n-type diffusion layer-forming composition. For example, the time may be selected from a range of from 1 minute to 60 minutes, preferably from 2 minutes to 30 minutes.

Since a glass layer of phosphoric acid glass (not shown) or the like is formed on a surface of the n-type diffusion layer 12, etching is performed in order to remove the phosphoric acid glass. The etching may be performed by a known method such as a method of dipping in an acid such as hydrofluoric acid or an alkali such as caustic soda.

In the method of forming an n-type diffusion layer in which the n-type diffusion layer 12 is formed with the n-type diffusion layer-forming composition 11, as shown in Figs. 1(2) and (3), an n-type diffusion layer 12 is formed at a desired portion without forming an unnecessary n-type diffusion layer at a back surface or at a side surface.

Accordingly, a side etching process for removing an unnecessary n-type diffusion layer formed at a side surface, which is an essential process in a method of forming an n-type diffusion layer by a conventional gas phase reaction method, can be omitted in the production method of the invention and the thus process can be simplified.

Further, in the conventional production method, it is necessary to convert the unnecessary n-type diffusion layer formed at the back surface to a p⁺-type diffusion layer. For this purpose, a method in which a paste of aluminum, which is an element in group 13, is applied on the n-type diffusion layer at the back surface, sintered and aluminum is diffused into the n-type diffusion layer so as to convert the same to a p⁺-type diffusion layer. In this method, since a certain amount of aluminum is necessary in order to ensure sufficient conversion to a p⁺-type diffusion layer and form a high concentration electric field layer (p⁺-type diffusion layer), a thick aluminum layer needs to be formed. However, since the coefficient of thermal expansion of aluminum is significantly different from that of silicon used as a semiconductor substrate, the process of sintering and cooling the aluminum layer may generate a large internal stress in the silicon substrate and cause warpage of the silicon substrate.

The internal stress may damage the grain boundary and increase the power loss. The warpage may cause breakage of a photovoltaic cell element upon transportation during a module assembly process or upon connection with a copper wire called a tab line. Recently, an element has become more prone to break due to a decrease in thickness of a silicon substrate associated with improvements in slice processing technique.

However, according to the production method of the invention, in which an unnecessary n-type diffusion layer is not formed at a back surface and there is no need to convert an n-type diffusion layer to a p⁺-type diffusion layer, formation a thick aluminum layer is not essential. As a result, generation of an internal stress in a semiconductor substrate or warpage of the semiconductor substrate can be suppressed. Consequently, an increase in power loss or breakage of an element can be suppressed.

Further, in the production method of the invention, a method for forming a p⁺-type diffusion layer (high density electric field layer) 14 is not limited to a method of converting an n-type diffusion layer made of aluminum to a p⁺-type diffusion layer, and may be selected from a wider range of options.

For example, a p⁺-type diffusion layer (high density electric field layer) 14 is preferably formed by applying a p-type diffusion layer-forming composition 13 to a back surface of a p-type semiconductor substrate 10 (a surface opposite to a surface on which an n-type diffusion layer-forming composition has been applied) and performing sintering. In this process, the specific metal atoms included in the p-type diffusion layer-forming composition 13 are diffused in the p⁺- type diffusion layer 14. In this way, lattice distortion, which is due to plastic deformation that occurs in a region in which p-type impurity atoms (such as boron atoms) are diffused at high concentration, is relaxed and generation of defects is suppressed. The specific metal atoms diffused in a p⁺-type diffusion layer are preferably included in a surface layer of the p⁺-type diffusion layer at a concentration of 1×10¹⁷ atoms/cm³ or more. From the viewpoint of suppressing diffusion of p-type impurity atoms by reducing the lattice defects, the concentration of the specific metal atoms is preferably in a range of 1×10¹⁷ atoms/cm³ to 1×10²⁰ atoms/cm³ so as not to be too high.

Further, as described later, the material used for the surface electrode 20 at the back surface is not limited to aluminum in group 13, and Ag (silver), Cu (copper) and the like may be used. In addition, the surface electrode 20 at the back surface may be thinner than the conventional surface electrode 20.

As shown in Fig. 1 (4), an antireflection film 16 is formed on the n-type diffusion layer 12. The antireflection film 16 is formed by a known technique. For example, in a case in which the antireflection film 16 is a silicon nitride film, it is formed by a plasma CVD method using a mixed gas of SiH₄ and NH₃ as a raw material. At this time, hydrogen is diffused in a crystal and an orbital that does not contribute to bonding to a silicon atom, i.e., a dangling bond, is bound to hydrogen, thereby inactivating a defect (hydrogen passivation).

More specifically, the antireflection layer is formed at a mixed gas flow ratio NH₃/SiH₄ of from 0.05 to 1.0, a pressure in a reaction chamber of from 13.3 Pa (0.1 Torr) to 266.6 Pa (2 Torr), a temperature during film formation of from 300°C to 550°C, and a frequency for plasma discharge of 100 kHz or more.

As shown in Fig. 1(5), a metal paste for a front electrode 17 is applied onto the antireflection film 18 at the front surface (light-receiving surface) by screen printing and dried, whereby a metal paste layer for a front electrode 17 is formed. The metal paste for a front electrode includes (1) metal particles and (2) glass particles as essential components, and (3) a resin binder and (4) other additives, as necessary.

A back surface electrode 20 is formed also on a p⁺-type diffusion layer (high density electric field layer) 14 at the back surface. As mentioned previously, the material or the formation process of the back side electrode 20 are not particularly limited in the invention. For example, the back side electrode 20 may be formed by applying a paste for forming a back surface electrode that includes a metal such as aluminum, silver or copper, and drying the same. At this time, a silver paste for forming a silver electrode may be provided at a portion of the back surface for the purpose of connecting the element with another element during a module assembly process.

As shown in Fig. 1(6), an electrode is sintered and a photovoltaic cell element is formed. When sintering is performed at a temperature of from 600°C to 900°C for from several seconds to several minutes, the antireflection film, which is an insulating film, is melted by the glass particles included in a metal paste for forming an electrode at the front surface. Further, a part of the surface of silicon 10 is also melted, whereby a contact portion between the metal particles (such as silver particles) in the paste and the silicon substrate 10 is formed and solidified. As a result, electrical conduction between the front surface electrode 18 and the silicon substrate 10 is formed. This process is referred to as a fire through.

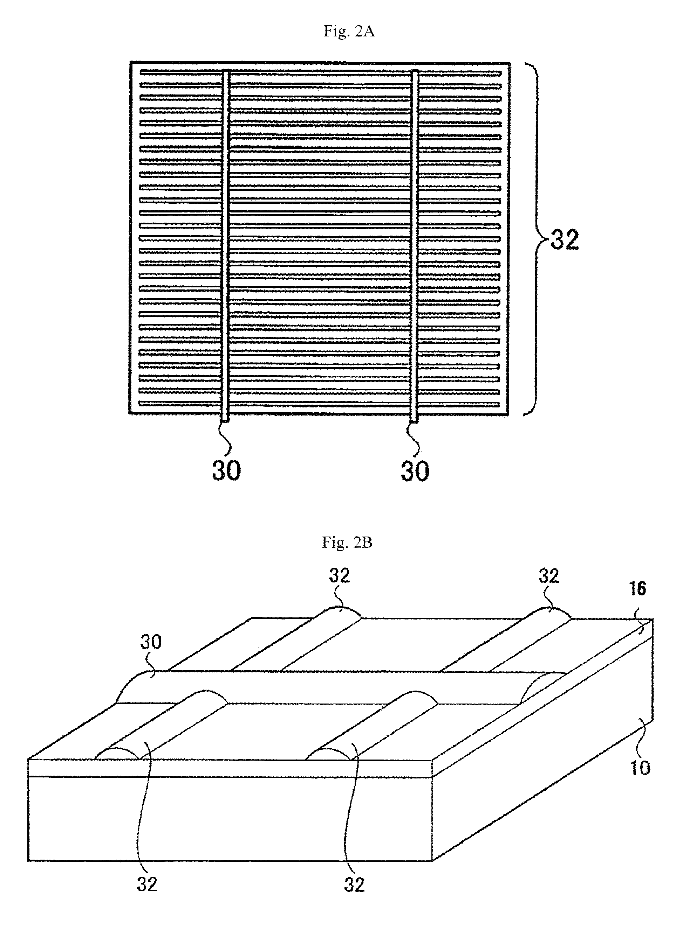

The shape of the front electrode 18 is explained. The front electrode 18 is formed from a bus bar electrode 30 and a finger electrode 32 that intersects with the bus bar electrode 30. Fig. 2(A) is a plan view of a front side of a photovoltaic cell element having a structure in which a front surface electrode 18 is formed from a bus bar electrode 30 and a finger electrode 32 that intersects with the bus bar electrode 30. Fig. 2(B) is a perspective view of an enlarged portion of the structure shown in Fig. 2(A).

The front surface electrode 18 can be formed by applying a metal paste by screen printing, plating with an electrode material, or evaporating an electrode material under high vacuum by electron beam heating. The front surface electrode 18 including the bus bar electrode 30 and the finger electrode 32 is a known electrode generally used as an electrode for the light-receiving side, and may be formed by a known process for forming the bus bar electrode and the finger electrode for the light-receiving side.

The embodiment as described above relates to a photovoltaic cell element having an n-type diffusion layer at the front surface and a p⁺-type diffusion layer at the back surface, and a front surface electrode and a back surface electrode are formed on these diffusion layers, respectively. However, it is also possible to produce a photovoltaic cell element having a selective emitter structure by using a semiconductor substrate produced by using the impurity diffusion layer-forming composition as described above, which is applicable to patterning.

The photovoltaic cell element having a selective emitter structure for the purpose of achieving high efficiency has two kinds of n-type diffusion layers having different impurity concentrations, in which the impurity concentration is high at the n-type diffusion layer immediately under an electrode and low at the other regions for receiving light. The n-type impurity diffusion layer-forming composition may be used also for the formation of a high concentration diffusion layer immediately under an electrode.

In the photovoltaic cell element having a selective emitter structure, it is preferred that a high concentration region with an n-type impurity concentration of 1.00×10²⁰ atoms/cm³ or more exists in an n⁺-type diffusion layer at a depth of from 0.10 µm to 1.0 µm from a surface of a p-type semiconductor substrate. More preferably, the high concentration region exists in an n⁺-type diffusion layer at a depth of from 0.12 µm to 1.0 µm, further preferably at a depth of from 0.15 µm to 1.0 µm. Generally, the concentration of the diffused impurity is lower at a deeper portion from the surface of the substrate. Therefore, if a high concentration region exists at a portion at a depth in a range as described above, a favorable ohmic contact with an electrode can be achieved at a region with a sufficiently high impurity concentration, even in a case in which a surface of the substrate is eroded by a glass component in the electrode-forming material for forming an electrode on the n⁺-type diffusion layer.

The impurity concentration in a depth direction of the semiconductor substrate can be measured by performing secondary ion mass spectrometry (SIMS) by an ordinary method with IMS-7F (AMETEK, Inc - CAMECA SAS).

Further, in the photovoltaic cell element, in a case in which a sheet resistivity at a surface of the n⁺-type diffusion layer is from 20 Ω/□ to 40 Ω/□, the concentration gradient of an n-type impurity at a region of from the surface to 0.1 µm in depth is -9.00×10²¹ atoms/(cm³·µm) or more, more preferably -8.00×10²¹ atoms/(cm³·µm) or more. When the concentration gradient of the n-type impurity at a region of from the surface to 0.1 µm in depth is within the range, the carrier collection efficiency tends to further improve.

The concentration gradient of the n-type impurity at a region of from the surface to 0.1 µm in depth is calculated by dividing a difference in the n-type impurity concentration, which is obtained by deducting the n-type impurity concentration at the surface from the n-type impurity concentration at a point of 0.1 µm in depth from the surface, by the distance (0.1 µm).

When the n-type impurity diffusion layer-forming composition is used in the method of forming an n⁺-type diffusion layer in which an impurity is diffused at high concentration at a portion that is deep from the surface, the sheet resistivity at the surface of the n⁺-type diffusion layer is preferably from 20 Ω/□ to 60 Ω/□, more preferably from 20 Ω/□ to 40 Ω/□.

The sheet resistivity can be measured by a four probe method at 25°C with a low resistivity meter (Loresta-EP MCP-T360, Mitsubishi Chemical Analytech Co., Ltd.) In the invention, the sheet resistivity is evaluated as an arithmetic average value of the values measured at 25 points.

Further, the layer thickness of the n⁺-type diffusion layer (i.e., a junction depth) is preferably in a range of from 0.5 µm to 3 µm, more preferably in a range of from 0.6 µm to 2 µm.

The layer thickness of the n⁺-type diffusion layer (i.e., a junction depth) is calculated by measuring the impurity concentration in a depth direction of the semiconductor substrate, and determining a depth at which the impurity concentration is 1.00×10¹⁶ atoms/cm³ or less.

In the production method of the photovoltaic cell element having a selective emitter structure, an n-type diffusion layer having a low impurity concentration (hereinafter, also referred to as a "second n-type diffusion layer") is formed in a region other than a region in which an n⁺- type diffusion layer having a high impurity concentration (hereinafter, also referred to as a "first n-type diffusion layer") is formed. Examples of the method of forming the second n-type diffusion layer include a method of performing a thermal diffusion treatment by applying the n-type impurity diffusion layer-forming composition, or a method of performing a thermal treatment in an atmosphere including an n-type impurity.

In a case in which the second n-type diffusion layer is formed with the n-type diffusion layer-forming composition, an n-type impurity diffusion layer-forming composition having a low impurity concentration is preferably used. In a method of applying two kinds of n-type impurity diffusion layer-forming composition having different impurity concentrations, it is possible to form an n⁺-type diffusion layer at a region at which an electrode is to be formed with an n-type diffusion layer-forming composition having a high impurity concentration, and form an n-type diffusion layer at a region for receiving light with an n-type diffusion layer-forming composition having a low impurity concentration.

In that case, the n⁺-type diffusion layer and the n-type diffusion layer may be formed by performing a thermal diffusion layer, respectively, but the n⁺-type diffusion layer and the n-type diffusion layer are preferably formed at the same time.

In a method of forming a second n-type diffusion layer by performing a thermal treatment in an atmosphere including an n-type impurity, the atmosphere is not particularly limited as long as an n-type impurity is included therein. Examples of the atmosphere include a mixed gas of phosphorus oxychloride (POCl₃), nitrogen and oxygen. The conditions for the thermal treatment are the same as the conditions as described above.

In the second n-type diffusion layer, the sheet resistivity at the surface is preferably approximately 100 Ω/□. Further, the impurity concentration at the surface is preferably from 1.00×10¹⁸ atoms/cm³ to 1.00×10²⁰ atoms/cm³ and the layer thickness (junction depth) is preferably from 0.2 µm to 0.3 µm. In that case, recombination of carriers generated upon light irradiation can be suppressed, and carriers can be efficiently collected at the first n-type diffusion layer.

It is also possible to produce a back contact-type photovoltaic cell element by using a semiconductor substrate that is produced by using both an n-type impurity diffusion layer-forming composition and a p-type impurity diffusion layer-forming composition.

The back contact-type photovoltaic cell element, which is designed to improve efficiency, has a structure having a back surface on which an n⁺-type diffusion layer and a p⁺-type diffusion layer are alternately positioned, and an electrode is formed on each of the impurity diffusion layers. By using the n-type impurity diffusion layer-forming composition, it is possible to selectively form a p⁺-type diffusion layer at a specific region.

In a case in which the impurity diffusion layer-forming composition is used for the formation of the impurity diffusion layer, the specific metal atoms included in the impurity diffusion layer-forming composition are also diffused in the impurity diffusion layer. In particular, at a region of a top layer at which the specific metal atoms are diffused at high concentration, the surrface is slightly roughened. The reason for this is thought to be that the solubility of silicon with respect to hydrofluoric acid is improved due to the specific metal atoms included in the substrate.

As a result, it becomes easy to discern the impurity diffusion layer and suppress occurrence of mislocation between an electrode and the impurity diffusion layer during formation of the electrode.

The roughness at the surface is observed as concave profiles having an average depth of from 0.004 µm to 0.1 µm, which is sufficiently small so as not to affect the power generation characteristics. Further, the roughness at the surface measured as an arithmetic average roughness Ra is approximately from 0.004 µm to 0.1 µm.

The roughness at the surface can be observed with a scanning electron microscope (SEM). The arithmetic average roughness can be measured by a method of JIS B 0601, with a profile measuring laser microscope (VK-9700, Keyence Corporation).

### <Photovoltaic Cell>

The photovoltaic cell of the invention include at least one of the photovoltaic cell element as described above, and a wiring material (tab line) positioned on the electrode of the photovoltaic cell element. As necessary, the photovoltaic cell may have a structure in which plural photovoltaic cell elements are connected via a wiring material and sealed with a sealing material. The wiring material and the sealing material are not particularly limited, and may be selected from the materials that are conventionally used.

### [Examples]

In the following, the invention is explained with reference to the Examples. However, the invention is not limited to these Examples. Unless otherwise specified, the "%" is based on mass.

### (Example 1)

An n-type impurity diffusion layer-forming composition was prepared by mixing 10 g of a P₂O₅-SiO₂-CaO glass powder (approximately spherical, average particle diameter: 1.0 µm, softening temperature: 700°C, P₂O₅: 50%, SiO₂: 43%, CaO: 7%), 6.8 g of ethyl cellulose and 83.2 g of terpineol in an automatic mortar, thereby obtaining a paste.

Subsequently, the paste was applied onto an entire surface of a p-type silicon substrate by screen printing, dried at 150°C for 10 minutes, and debindered at 400°C for 3 minutes. Next, a thermal treatment was performed in an air atmosphere at 900°C for 10 minutes and n-type impurity atoms were diffused in the silicon substrate, whereby an n-type diffusion layer was formed. A semiconductor substrate having a p-type semiconductor layer and an n-type diffusion layer was thus obtained.

Then, a glass layer remaining on the surface of the silicon substrate was removed with hydrofluoric acid.

The sheet resistivity at the surface at which the n-type impurity diffusion layer-forming composition was applied was 35 Ω/□, and it was confirmed that an n-type diffusion layer was formed by diffusion of P (phosphorus). The sheet resistivity at the back surface was 1,000,000 Ω/□ or more and could not be measured, and it was confirmed that an n-type diffusion layer was not substantially formed.

The sheet resistivity was calculated as an arithmetic average value of the values measured at 25 points at 25°C with a low resistivity meter (Loresta-EP MCP-T360, Mitsubishi Chemical Analytech Co., Ltd.)

Further, the existence of an element other than the n-type impurity atom in the n-type diffusion layer was confirmed by secondary ion mass spectrometry (SIMS). The content of Ca at a surface in the n-type diffusion layer was 1×10¹⁷ atoms/cm³. The SIMS was performed by an ordinary method with IMS-7F (AMETEK, Inc - CAMECA SAS).

### (Example 2)

A semiconductor substrate having a p-type semiconductor layer and an n-type diffusion layer was obtained by forming an n-type diffusion layer in a similar manner to Example 1, except that the thermal diffusion treatment was performed for 30 minutes.

The sheet resistivity at the surface at which the n-type impurity diffusion layer-forming composition was applied was 24 Ω/□, and it was confirmed that an n-type diffusion layer was formed by diffusion of P (phosphorus). The sheet resistivity at the back surface was 1,000,000 Ω/□ or more and could not be measured, and it was confirmed that an n-type diffusion layer was not substantially formed.

The content of Ca at a surface in the n-type diffusion layer was 1×10¹⁹ atoms/cm³.

### (Example 3)

A semiconductor substrate having a p-type semiconductor layer and an n-type diffusion layer was obtained by forming an n-type diffusion layer in a similar manner to Example 1, except that a P₂O₅-SiO₂-MgO glass powder (approximately spherical, average particle diameter: 1.0 µm, softening temperature: 700°C, P₂O₅: 50%, SiO₂: 43%, MgO: 7%) was used.

The sheet resistivity at the surface at which the n-type impurity diffusion layer-forming composition was applied was 30 Ω/□, and it was confirmed that an n-type diffusion layer was formed by diffusion of P (phosphorus). The sheet resistivity at the back surface was 1,000,000 Ω/□ or more and could not be measured, and it was confirmed that an n-type diffusion layer was not substantially formed.

The content of Mg at a surface in the n-type diffusion layer was 1×10¹⁹ atoms/cm³.

### (Preparation of photovoltaic cell element)

Photovoltaic cell elements were prepared by using the semiconductor substrates having an n-type diffusion layer obtained in Examples 1 to 3, by forming an antireflection film at the light-receiving surface, a front surface electrode at a region of the front surface for forming an electrode, and a back surface electrode at the back surface, respectively.

The photovoltaic cell elements exhibited an improvement in conversion efficiency by 0.1 %, as compared with a photovoltaic cell element in which an n-type diffusion layer was formed by an ordinary gas phase diffusion method using phosphorus oxychloride.

### (Example 4)

### (Preparation of photovoltaic cell element having selective emitter structure)

The n-type impurity diffusion layer-forming composition of Example 1 was applied onto a surface of a p-type silicon substrate by screen printing into the shape of a finger of 150 µm in width and a bus bar of 1.5 mm in width, and dried at 150°C for 10 minutes.

Subsequently, the silicon substrate was subjected to a thermal treatment in an atmosphere at 900°C for 10 minutes so that the n-type impurity was diffused into the silicon substrate, whereby an n⁺-type diffusion layer (first n-type diffusion layer) was formed at a region for forming an electrode. Then, the silicon substrate was subject to a thermal treatment in a mixed gas atmosphere of phosphorus oxychloride (POCl₃), nitrogen and oxygen at 830°C for 10 minutes so that the n-type impurity was diffused into the silicon substrate, whereby a second n-type diffusion layer was formed at a region for receiving light. Thereafter, a glass layer remaining on the surface of the silicon substrate was removed with hydrofluoric acid.

The average value of the sheet resistivity at the surface of the n⁺-type diffusion layer (first n-type diffusion layer) was 35 Ω/□, and the average value of the sheet resistivity at the surface of the other n-type diffusion layer (second n-type diffusion layer) was 102 Ω/□.

The concentration of an element other than the n-type impurity atoms that exists in the n⁺- type diffusion layer was measured by secondary ion mass spectrometry (SIMS). As a result, the content of Ca at the surface in the n⁺-type diffusion layer was 1×10¹⁷ atoms/cm³.

The concentration of P (phosphorus) atoms (n-type impurity atoms) in depth in the region at which the first n-type diffusion layer (n⁺-type diffusion layer) was formed was measured by secondary ion mass spectrometry (SIMS) by an ordinary method with IMS-7F (AMETEK, Inc - CAMECA SAS).

The n-type impurity concentration at a position of 0.020 µm in depth from a surface of the n⁺-type diffusion layer (hereinafter, also referred to as an "n-type impurity concentration at the surface) was 1.01×10²¹ atoms/cm³, and the n-type impurity concentration at a position of 0.1 µm in depth was 1.46×10²⁰ atoms/cm³. Accordingly, the concentration gradient of the n-type impurity atoms from the surface to a depth of 0.1 µm was -8.64×10²¹ atoms/(cm³·µm).

Further, in the n⁺-type diffusion layer, a region in which the n-type impurity concentration was 1.00×10²⁰ atoms/cm³ or more was formed from the surface to a depth of 0.13 µm.

The surface of the first n-type diffusion layer was roughened and a concave profile was formed. The arithmetic average roughness Ra was measured with a profile measuring laser microscope (VK-9700, Keyence Corporation) by a method of JIS B 0601, and the Ra was 0.05 µm. The object for the measurement was a portion of a texture formed on the surface of the silicon substrate, which was one of four triangle faces of a pyramid of 5 µm in height and 20 µm in base, approximately. The measurement length was set at 5 µm in view of the minute scale of the object. The evaluation length may be longer than 5 µm, and in that case, the roughness at the surface of the n⁺-type diffusion layer needs to be cut off. Prior to the measurement, calibration of the measured value was performed by using a standard roughness scale such as No. 178-605, Mitutoyo Corporation.

In a similar manner, the n-type impurity concentration in a depth direction at a region at which the second n-type diffusion layer was formed was measured.

The n-type impurity concentration at the surface of the second n-type diffusion layer was 1.00×10²¹ atoms/cm³, and the n-type impurity concentration at a depth of 0.1 µm was 2.79×10¹⁸ atoms/cm³. Accordingly, the n-type impurity concentration gradient from the surface to 0.1 µm in depth was -9.97×10²¹ atoms/(cm³·µm).

In the second n-type diffusion layer, a region at which the n-type impurity concentration was 1.00×10²⁰ atoms/cm³ or more was formed from the surface to 0.02 µm in depth.

A photovoltaic cell element was prepared by using the silicon substrate having the first and the second n-type diffusion layer at the light-receiving surface as prepared above, by forming an antireflection film at the light-receiving surface, a front surface electrode at a region for forming an electrode, and a back surface electrode at a back surface, respectively by an ordinary method. The light-receiving electrode included a finger of 100 µm in width and a bus bar of 1.1 mm in width. Specifically, the light-receiving electrode was formed by a screen printing machine equipped with an alignment system regulated by a CCD camera, such that a region for applying an electrode paste corresponded to a region at which the first n-type diffusion layer was formed. After application of the electrode paste, a thermal treatment was performed.

A portion at which the light-receiving electrode was formed was observed with a microscope. As a result, there was no misalignment of the region at which the electrode was formed and the region at which the first n-type diffusion layer was formed. It was also confirmed that the first n-type diffusion layer was wider than the electrode by 25 µm at both sides, respectively, at a finger portion.

The obtained photovoltaic cell exhibited an improvement in conversion efficiency of 0.5%, as compared with a photovoltaic cell not having a region for forming an electrode at which a high-concentration n⁺-type diffusion layer was formed (selective emitter)

### (Example 5)

A p-type impurity diffusion layer-forming composition was prepared by mixing 20 g of a B₂O₃-SiO₂-Na₂O glass powder (approximately spherical, average particle diameter: 4.9 µm, softening temperature: 561°C, product name: TMX-404, Tokan Material Technology Co., Ltd.), 0.5 g of ethyl cellulose and 10 g of terpineol in an automatic mortar, thereby obtaining a paste.

Subsequently, the paste was applied onto a back surface of a p-type silicon substrate having an n-type diffusion layer at a front surface by screen printing, dried at 150°C for 5 minutes with a hot plate, and debindered at 400°C for 3 minutes. Next, a thermal treatment was performed in an air atmosphere at 950°C for 30 minutes and p-type impurity atoms were diffused in the silicon substrate, whereby a p⁺-type diffusion layer was formed.

Then, a glass layer remaining on the surface of the silicon substrate was removed with hydrofluoric acid.

The sheet resistivity at the surface at which the p-type impurity diffusion layer-forming composition was applied was 60 Ω/□, and it was confirmed that the p⁺-type diffusion layer was formed by diffusion of B (boron).

The existence of an element other than the p-type impurity atoms in the p⁺-type diffusion layer was determined by secondary ion mass spectrometry (SIMS). As a result, the content of Na at the surface in the p⁺-type diffusion was 1×10¹⁷ atoms/cm³.

### (Example 6)

A semiconductor substrate was obtained by forming a p⁺-type diffusion layer in a similar manner to Example 5, except that the thermal diffusion treatment was performed at 1000°C for 10 minutes.

The sheet resistivity at the surface at which the p-type diffusion layer-forming composition was applied was 40 Ω/□, and it was confirmed that the p⁺-type diffusion layer was formed by diffusion of B (boron).

The content of Na at the surface in the p⁺-type diffusion layer was 1×10¹⁹ atoms/cm³.

### (Example 7)

A semiconductor substrate was obtained by forming a p⁺-type diffusion layer in a similar manner to Example 5, except that a B₂O₃-SiO₂-CaO glass powder (approximately spherical, average particle diameter: 5.1 µm, softening temperature: 808°C, product name: TMX-403, Tokan Material Technology Co., Ltd.) was used.

The sheet resistivity at the surface at which the p-type diffusion layer-forming composition was applied was 65 Ω/□, and it was confirmed that the p⁺-type diffusion layer was formed by diffusion of B (boron).

The content of Ca in the surface of the p⁺-type diffusion layer was 1×10¹⁷ atoms/cm³.

### (Preparation of photovoltaic cell element)

Photovoltaic cell elements were prepared by using the silicon substrates having a p⁺-type diffusion layer obtained in Examples 5 to 7 were prepared by forming an antireflection film at the front surface, a front surface electrode at a region for forming an electrode at the front surface, and a back surface electrode at a back surface, respectively by an ordinary method.

The obtained photovoltaic cell elements exhibited an improvement in conversion efficiency of 0.07%, as compared with a photovoltaic cell element prepared by using a conventional p-type impurity diffusion layer-forming composition including a boron compound.

### (Example 8)

A p⁺-type diffusion layer was formed by applying the p-type impurity diffusion layer-forming composition prepared in Example 5 onto a surface of an n-type silicon substrate in a similar manner to Example 1, except that the p-type impurity diffusion layer-forming composition was applied into a patterned shape having a finger of 150 µm in width and a bus bar of 1.5 mm in width, by using a screen printing machine.

The surface of the p⁺-type diffusion layer was observed with a SEM (magnification: 10,000), and it was confirmed that the surface was roughened and a concave profile was formed. The arithmetic average roughness Ra was 0.06 µm.

The average value of the sheet resistivity at the surface of the p⁺-type diffusion layer was 65 Ω/□.

The existence of an element other than the p-type impurity atoms in the p⁺-type diffusion layer was confirmed by secondary ion mass spectrometry (SIMS). As a result, the content of Na at the surface in the p⁺-type diffusion layer was 1×10¹⁷ atoms/cm³.

An electrode was formed on the p⁺-type diffusion layer such that the finger portion was 100 µm in width and the bus bar portion was 1.1 mm in width. Specifically, alignment of the position to which an electrode paste was to be applied and the p⁺-type diffusion layer was performed with a screen printing machine equipped with an alignment system regulated with a CCD camera, and an electrode was formed by performing the applied electrode paste.

The region of the electrode and the region of the p⁺-type diffusion layer were observed with a microscope. As a result, misalignment was not observed and the p⁺-type diffusion layer was wider than the finger portion of the electrode by 25 µm at both sides, respectively.

### (Comparative Example 1)

A semiconductor substrate was obtained by forming an n-type diffusion layer in a similar manner to Example 1, except that the n-type impurity diffusion layer-forming composition was prepared by using a P₂O₅-SiO₂ glass powder including iron (Fe) by 1%.

The sheet resistivity at the surface at which the n-type diffusion layer-forming composition was applied 34 Ω/□, and it was conformed that an n-type diffusion layer was formed by diffusion of P (phosphorus). The sheet resistivity at the back surface was 1,000,000 Ω/□ or more and could not be measured, and it was confirmed that an n-type diffusion layer was not substantially formed.

The content of Fe at the surface in the n-type diffusion layer was 1×10¹⁷ atoms/cm³.

A photovoltaic cell element was prepared by using the silicon substrate having an n-type diffusion layer obtained above, by forming an antireflection film at the surface, a front surface electrode at a region for forming an electrode, and a back surface electrode at the back surface, by an ordinary method, respectively. The photovoltaic cell element exhibited a lower photo conversion characteristic as compared with a photovoltaic cell element having an n-type diffusion layer formed by a conventional gas phase diffusion method with phosphorus oxychloride.

### (Comparative Example 2)

A semiconductor substrate was obtained by forming a p⁺-type diffusion layer in a similar manner to Example 5, except that a p-type diffusion layer-forming composition was prepared by using a B₂O₅-SiO₂ glass powder including iron (Fe) as the glass powder.

The sheet resistance at the surface at which the p-type diffusion layer-forming composition was applied was 63 Ω/□, and it was conformed that a p⁺-type diffusion layer was formed by diffusion of B (boron).

The content of Fe at the surface in the n-type diffusion layer was 1×10¹⁷ atoms/cm³.

A photovoltaic cell element was prepared by using the silicon substrate obtained above, by forming an antireflection film at the surface, a front surface electrode at a region for forming an electrode, and a back surface electrode at the back surface, by an ordinary method, respectively. The photovoltaic cell element exhibited a significantly low photo conversion characteristic as compared with a photovoltaic cell element having a p-type diffusion layer formed by using a conventional p-type diffusion layer-forming composition including a boron compound.

The disclosures of Japanese Patent Application Nos. 2011-162646, 2011-162647 and 2011-162645 are incorporated by reference herein.

All publications, patent applications, and technical standards mentioned in this specification are herein incorporated by reference to the same extent as if each individual publication, patent application, or technical standard was specifically and individually indicated to be incorporated by reference.

## Claims

1. A semiconductor substrate having a semiconductor layer and an impurity diffusion layer, the impurity diffusion layer comprising:
at least one metal atom selected from the group consisting of K, Na, Li, Ba, Sr, Ca, Mg, Be, Zn, Pb, Cd, V, Sn, Zr, Mo, La, Nb, Ta, Y, Ti, Zr, Ge, Te and Lu; and
at least one impurity atom selected from the group consisting of an n-type impurity atom and a p-type impurity atom.

2. The semiconductor substrate according to claim 1, wherein a content of the metal atom at a surface of the impurity diffusion layer is 1×10¹⁷ atoms/cm³ or more.

3. The semiconductor substrate according to claim 1 or 2, wherein the n-type impurity atom is at least one selected from the group consisting of P and Sb.

4. The semiconductor substrate according to claim 1 or 2, wherein the p-type impurity atom is at least one selected from the group consisting of B and Ga.

5. The semiconductor substrate according to any one of claims 1 to 3, wherein the impurity diffusion layer comprises an n-type impurity atom, and is formed by performing a thermal treatment to a glass powder that is applied onto at least one surface of the semiconductor layer, the glass powder comprising:
at least one n-type impurity-containing substance selected from the group consisting of P₂O₃, P₂O₅ and Sb₂O₃; and
at least one glass component substance selected from the group consisting of SiO₂, K₂O, Na₂O, Li₂O, BaO, SrO, CaO, MgO, BeO, ZnO, PbO, CdO, V₂O₅, SnO, ZrO₂ and MoO₃.

6. The semiconductor substrate according to any one of claims 1, 2 and 4, wherein the impurity diffusion layer comprises a p-type impurity atom, and is formed by performing a thermal treatment to a glass powder that is applied onto at least one surface of the semiconductor layer, the glass powder comprising:
at least one p-type impurity-containing substance selected from the group consisting of B₂O₃ and Ga₂O₃; and
at least one glass component substance selected from the group consisting of SiO₂, K₂O, Na₂O, Li₂O, BaO, SrO, CaO, MgO, BeO, ZnO, PbO, CdO, V₂O₅, SnO, ZrO₂ and MoO₃.

7. A photovoltaic cell element, comprising the semiconductor substrate according to any one of claims 1 to 6, and an electrode disposed on the impurity diffusion layer.

8. A photovoltaic cell, comprising the photovoltaic cell element according to claim 7 and a wiring material disposed on the electrode.

9. A method of producing the semiconductor substrate according to any one of claims 1 to 6, the method comprising:
a step of applying, onto at least one surface of the semiconductor layer, an impurity diffusion layer-forming composition that comprises a glass powder and a dispersion medium, the glass powder including at least one impurity atom selected from the group consisting of an n-type impurity atom and a p-type impurity atom; and
a step of forming an impurity diffusion layer by performing a thermal diffusion treatment on the applied impurity diffusion layer-forming composition.
